Europäisches Patentamt

European Patent Office

Office européen des brevets

(11) Publication number: **0 685 853 A1**

# EUROPEAN PATENT APPLICATION

(21) Application number: **94830263.3**

(22) Date of filing: **31.05.94**

(51) Int. Cl.6: **G11C 16/06**

(43) Date of publication of application:
**06.12.95 Bulletin 95/49**

(84) Designated Contracting States:
**DE FR GB IT**

(71) Applicant: **SGS-THOMSON MICROELECTRONICS S.r.l.**
**Via C. Olivetti, 2**
**I-20041 Agrate Brianza (Milano) (IT)**

(72) Inventor: **Campardo, Giovanni**
**Via Segantini, 5**
**I-24100 Bergamo (IT)**
Inventor: **Silvagni, Andrea**
**Via A. Del Castagno, 5**
**I-20100 Milano (IT)**

(74) Representative: **Checcacci, Giorgio**
**PORTA, CHECCACCI & BOTTI s.r.l.**
**Viale Sabotino, 19/2**
**I-20135 Milano (IT)**

(54) **Method for erasing an EEPROM flash memory cell and corresponding erasing circuit.**

(57) A method for erasing a plurality of non-volatile memory cells of the flash EEPROM type each comprising a floating gate transistor and incorporated in a memory matrix calls for a potential (Ve) varying in time slowly in relation to the total erasing time discretely with a stepped wave form between a minimum initial value and a maximum final value is applied directly to the source terminal (S) of the transistors forming the non-volatile memory cells (1).

In this manner it is possible to erase any number of memory cells and in particular a very small number.

Fig. 1

Rank Xerox (UK) Business Services
(3.10/3.09/3.3.4)

EP 0 685 853 A1

## Field of application

The present invention relates to a method for erasing a non-volatile memory cell with double polysilicon level and electrically programmable.

The present invention relates also to a circuit for erasing said memory cell operating in accordance with the above method.

The present invention concerns in particular but not exclusively a circuitry device for the generation of an erasing signal in EEPROM flash memory devices and the following description is made with reference to this field of application only to simplify the discussion.

As is known, a non-volatile memory cell comprises a special MOS transistor having, in addition to the usual control gate, drain, source and bulk terminals even an insulated floating gate.

The floating gate is completely insulated and exhibits a high impedance toward any other terminal of the cell. Therefore the charge stored in the related transistor can remain there for an indefinite time, even if power is removed from the circuit in which it is inserted.

The cell thus exhibits non-volatile memory characteristics.

The operation by which a charge is stored in the floating gate is defined cell 'programming' while the operation by which said charge is removed from the floating gate is defined 'erasing' of the cell.

IN a memory matrix of the flash EEPROM type the source terminals of all cells are connected to a common source line and consequently all the cells are erased simultaneously.

Normally the flash EEPROM memory circuits comprise a rather high number of cells organised in matrices.

But sometimes, e.g. on devices such as microcontrollers and the like, it may be necessary to provide memory registers, vectors or small matrices with non volatile memory cells.

Such registers can be useful e.g. for memorising information on the configuration of the device or other system parameters and hence must be erasable separately from the rest of the memory.

The erasing procedure must therefore be suited to erasing a limited number of cells (e.g. from 1 to 1000 bits).

## Known art

It is known that to erase the contents of a certain flash EEPROM memory cell it is necessary to bring appropriate voltage values to the cell terminals.

In particular, erasing of the cell is done by application of a very high voltage, in general derived from the programming reference voltage Vpp, at the source terminal.

The control gate terminal and the bulk are kept at a ground potential while the drain terminal is left floating.

In this manner there is created a strong electrical field between the floating gate and the source region and the negative charges are extracted from the floating gate due to the Fowler-Nordheim tunnelling effect (F-N).

A collateral effect of this polarisation is that the junction between the source region, kept at a high potential, and the bulk, kept at ground potential is reverse biased.

It is known that a reverse biased junction is characterised by a certain breakdown voltage beyond which the junction begins to conduct.

The voltage which we apply to the source terminal of the transistor during erasing must therefore always be less than the breakdown voltage of the junction between source region and bulk.

There is a dependency, quantified experimentally and known to those skilled in the art, between the breakdown voltage of said junction and the amount of charge accumulated in the floating gate of the transistor forming the memory cell.

In accordance with said dependency the breakdown voltage increases linearly during erasing of the cell progressively as the charge inside the floating gate decreases.

Thus, to optimise erasing time it is possible to apply to the source terminal a voltage which increases during erasing while always remaining below the threshold value set by the breakdown voltage.

The simplest method, used widely in known memory devices, to obtain this positive variation of voltage during erasing is to apply the erasing voltage to the common source line of all the memory cells through a resistive element.

The voltage drop on the resistive element reduces the potential on the common source line by a factor dependent upon the sum of the source currents of the cells.

In each individual cell the source current is given by the sum of two currents, the first denominated Fowler-Nordheim current, due to the migration of the electrons from the floating gate, and the second, which we can consider a parasitic current, between the source region and the bulk, denominated 'band to band tunnelling current'.

The 'band to band tunnelling current' prevails as an order of magnitude over the Fowler-Nordheim current.

This current is directly proportional to the charge accumulated in the floating gate and consequently its value decreases during cell erasing.

The source current of the cell is thus practically coincident in value with the 'band to band tunnelling current' and its behaviour can be attributed to the behaviour of the above current.

It follows that the total current on the source line, given by the sum of the individual source currents of the matrix cells, brings about a voltage drop on the resistive element which decreases in time during memory erasing.

It is possible to find the total current of the colon source line by multiplying the source current of a cell, normally on the order of 10nA, by the number of cells in the matrix.

The value of said current can be even rather high if the memory matrices are very big.

To have a voltage drop on the order of a few volts it is necessary to size appropriately the resistive element on the basis of the total source current.

If the memory matrix to be erased contains a limited number of cells the total source current is very small and consequently to have a not negligible voltage drop there must be placed in series with the source line a resistive element with very high value, difficult to provide and size on an integrated circuit.

The technical problem underlying the present invention is to conceive an erasing method which would permit erasing any number of memory cells and in particular a very small number while holding unchanged the normal erasing times.

## Summary of the invention

The solution idea underlying the present invention is to provide a circuit generating a voltage varying in time to be applied directly to the common source line of the memory cells to be erased.

On the basis of this solution idea the technical problem is solved by a method of the type indicated and defined in the characterising part of claims 1, 2, 3 and 4.

The technical problem is also solved by a circuit of the type indicated above and defined in the characterising part of claims 5 and following.

The characteristics and advantages of the circuit in accordance with the present invention are set forth in the description of an embodiment thereof given below by way of nonlimiting example with reference to the annexed drawings.

In the drawings -

## Brief description of the drawings

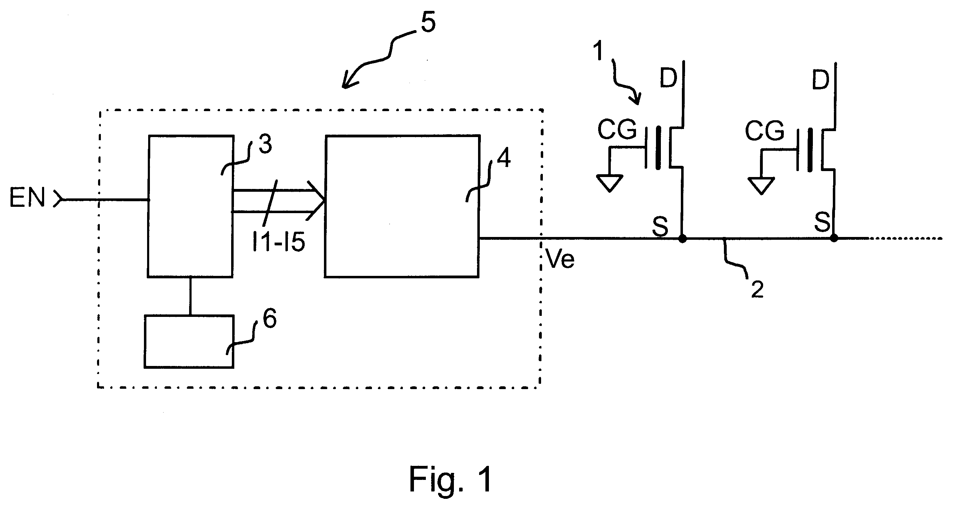

FIG. 1 shows a block diagram of a memory cell erasing circuit of the flash EEPROM type in accordance with the present invention,

FIG. 2 shows in particular an embodiment of a digital-analog converter incorporated in the device of FIG. 1,

FIG. 3 shows in particular an embodiment of an interface circuit incorporated in the digital-analog converter 4, and

FIG. 4 shows a wave form of a erasing signal obtained with a circuit in accordance with the present invention.

## Detailed description

With reference to the figures reference number 5 indicates as a whole and diagrammatically a circuit realised in accordance with the present invention for erasing of one or more EEPROM flash type non-volatile memory cells 1.

Each cell has control gate, drain and source terminals.

The cells are organised in matrices and said circuit 5 has an output terminal connected to a line 2 to which are also connected the source terminals S of all the cells of the matrix.

During the erasing phase the control gate terminal CG of said cells is connected to ground while the drain terminal D is floating.

The circuit 5 comprises a digital counter 3 interlocked with a timing signal generator 6 and with a digital-analog converter 4.

The digital counter 3 is enabled by an external signal AN which determines the beginning and end of the erasing phase.

The counting frequency is determined by the frequency of the signal supplied by the timing signal generator 6.

The output of the digital counter 3 is a digital signal which in the embodiment illustrated here consists of 5 bits and varies on 32 levels from 00000 to 11111.

The output signal enters the digital-analog converter 4 and is converted into a voltage signal Ve.

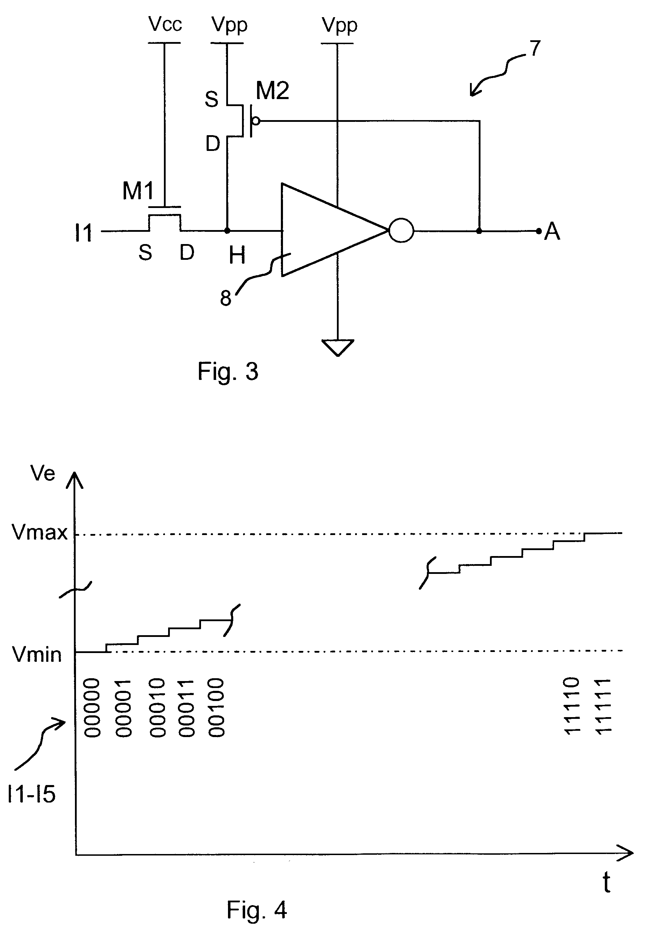

The voltage signal Ve whose behaviour is shown in FIG. 4 varies discretely with a basically stepped wave form between a minimum value Vmin and a maximum value Vmax.

As seen, this signal is applied to the common source line 2 to which are connected the source terminals S of all the cells of the matrix.

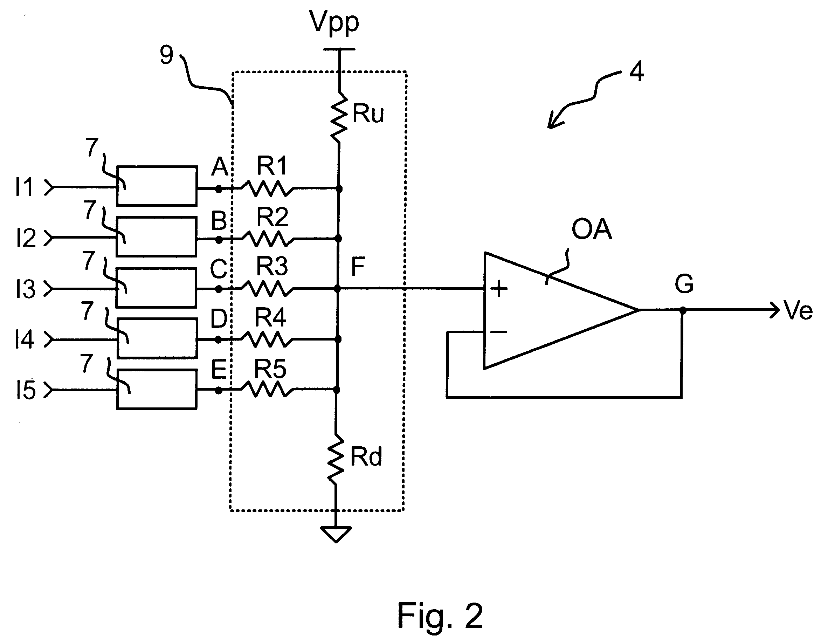

There is now described the structure of the digital analogue converter 4 shown in FIGS. 2 and 3.

The outputs I1-I5 of the digital counter 3 constitute the inputs of the digital-analog converter 4.

The binary signals present on the outputs I1-I5 each enter into an interface block 7.

The interface blocks 7 are all identical and serve to convert a logical signal having 'high' or 'logic 1' level and corresponding to a voltage of 5V into another voltage equal to the programming voltage Vpp.

These blocks can be e.g. provided in accordance with the circuit shown in FIG. 3 and described below.

The input of each interface block consists of the source terminal S of a first n-channel MOS transistor indicated by M1 while the gate terminal is kept at the reference power supply voltage Vcc and the drain terminal D is connected to the input of an inverter 8 and to the source terminal of a second p-channel MOS transistor, indicated by M2.

The output of the inverter 8 connected to the gate terminal of the second transistor M2 is the output of the interface block.

The gate terminal of the second transistor M2 and the power supply terminal of the inverter 8 are connected to the programming reference voltage Vpp.

Returning to FIG. 2, on the output nodes, indicated by the letters A, B, C, D and E, of the interface blocks 7 we find a potential of 0 volts if the input signal of the interface block is at 'low' or 'logical 0' level, or 12V (Vpp) if the input signal of the interface block is 'high' or 'logical 1' level.

These output nodes are each connected to a resistor and these resistors are indicated by R1-R5.

The remaining terminals of these resistors are connected to a common node F.

A resistor Ru connects the node F with the programming reference voltage Vpp while another resistor Rd connects the node F to ground.

To the node F is also connected the non-inverting input of an operational amplifier OA.

The operational amplifier OA has an output G connected in feedback to the inverting input.

The resistors Ru and Rd together with the resistors R1, R2, R3, R4 and R5 form a voltage divider whose dividing factor is discretely variable.

Indeed, the resistors R1-R5, depending on the potential present on the outputs of the interface blocks 7, are in parallel with the resistor Ru or the resistor Rd, the dividing factor changing in both cases.

If the values of the resistors R1-R5 are selected so as to reflect the 'weight' of the digital signal emerging from the counter, e.g. in the following manner:

$$R1 = R$$
$$R2 = 2*R$$
$$R3 = 4*R$$
$$R4 = 8*R$$
$$R5 = 16*R$$

With only five resistors it is possible to obtain a linear variation of the voltage signal Ve on $2^5 = 32$ levels as shown in FIG. 4.

Nothing would prevent using a counter and a digital-analog converter with a larger number of bits so as to obtain a larger number of levels or change the values of the resistors R1-R5 so as to obtain a non-linear change of the voltage signal Ve.

By changing the values of the resistors Ru and Rd it is possible to intervene on the initial and final voltages, Vmin and Vmax, of the erasing voltage Ve as appears clearly from the following formulas:

$$Vmin = Vpp*(Rtot1/(Ru + Rtot1))$$
$$Vmax = Vpp*(Rd/(Rd + Rtot2))$$

where

$$Rtot1 = Rd//R1//R2//R3//R4//R5$$
$$and\ Rtot2 = Ru//R1//R2//R3//R4//R5.$$

The operational amplifier OA is connected in voltage follower configuration and serves to decouple the node F of the divider from the common source line of the memory cells.

In conclusion, the circuit in accordance with the present invention allows erasing of a matrix of small EEPROM flash memory cells without the shortcomings found in the known art.

Of course modifications and variations can be made to the circuit described above by way of nonlimiting example all however falling within the protective scope of the following claims.

**Claims**

1. Method of erasing of an electrically programmable and erasable non-volatile memory cell (1) with double polysilicon level comprising a floating gate transistor and characterised in that a potential (Ve) which changes in time slowly in relation to the total erasing time is applied directly to the source terminal (S) of said transistor.

2. Method in accordance with claim 1 characterised in that said potential (Ve) varies discretely between a minimum initial value and a maximum final value.

3. Method in accordance with claim 1 characterised in that said potential (Ve) varies in time with a stepped wave form.

4. Method in accordance with any one of the above claims in which a plurality of cells is incorporated in a memory matrix and characterised in that said potential (Ve) is applied simultaneously to the source terminals (S) of the transistors forming said memory cells.

5. Circuit for erasing an electrically programmable and erasable non-volatile memory cell (1) with double polysilicon level and comprising a floating gate transistor of the type comprising means (5) of generation of an erasing voltage (Ve) and characterised in that said erasing voltage generation means comprise a digital counter (3) interlocked with a timing signal generator (6) and with a digital-analog converter (4) having at least one input terminal connected to at least one output terminal of said digital counter (3) and an output terminal connected to the source terminal (S) of said transistor to supply said erasing voltage (Ve).

6. Circuit in accordance with claim 5 in which a plurality of cells is incorporated in a memory matrix and characterised in that said output terminal of said digital counter (3) is connected to the source terminal (S) of the transistors forming said memory cells.

7. Circuit in accordance with either of claims 5 and 6 characterised in that said digital-analog converter (4) comprises resistive divider (9) having at least one end connected to a power supply pole (Vpp) and comprising at least one discretely varying resistive element.

8. Circuit in accordance with claim 7 characterised in that said discretely varying resistive element comprises a plurality of resistive elements.

9. Circuit in accordance with claim 8 characterised in that at least one terminal of at least one of said resistive elements is always connected to a fixed potential reference.

Fig. 1

EP 0 685 853 A1

Fig. 2

EP 0 685 853 A1

Vcc    Vpp        Vpp

7

S    M2

D

M1

I1    S    D    H

8

Fig. 3

Ve

Vmax

Vmin

00000 00001 00010 00011 00100          11110 11111

I1-I5

t

Fig. 4

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | US-A-5 051 953 (KITAZAWA ET AL) * column 7, line 24 - line 65; figure 1 * | 1-9 | G11C16/06 |
| Y | EP-A-0 432 050 (SGS-THOMSON MICROELECTRONICS SA) * column 5, line 44 - column 7, line 13; figures 3,4 * | 1-9 | |
| Y A | US-A-4 342 119 (SEIDL) * column 3, line 16 - line 56; figures 1,2B * | 5 2,3 | |
| Y | PETER H BEARDS 'Analog and Digital Electronics' 1991 , PRENTICE HALL INTERNATIONAL , HEMEL HEMPSTEAD, GB * page 488, line 26 - page 489, line 16; figure 18.4 * | 7-9 | |
| | | | **TECHNICAL FIELDS SEARCHED** (Int.Cl.6) |
| | | | G11C G01S H04K H03J |

The present search report has been drawn up for all claims

| Place of search | Date of completion of the search | Examiner |
|---|---|---|
| THE HAGUE | 24 October 1994 | Cummings, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)